Europäisches Patentamt

European Patent Office

Office européen des brevets

(11) Veröffentlichungsnummer: **0 419 709 A1**

# (12) EUROPÄISCHE PATENTANMELDUNG

(21) Anmeldenummer: 89117967.3

(22) Anmeldetag: 28.09.89

(51) Int. Cl.⁵: **H01L 23/66**

(43) Veröffentlichungstag der Anmeldung:
03.04.91 Patentblatt 91/14

(84) Benannte Vertragsstaaten:
**AT BE CH DE ES FR GB GR IT LI LU NL SE**

(71) Anmelder: **Siemens Aktiengesellschaft**
**Wittelsbacherplatz 2**
**W-8000 München 2(DE)**

(72) Erfinder: **Zimmermann, Walter, Ing. grad.**
**Eichenweg 9**
**W-8250 Dorfen 1(DE)**
Erfinder: **Hargasser, Hans, Dipl.-Ing. (FH)**
**Salzmannstrasse 46**
**W-8000 München 83(DE)**

(54) Gehäuse für Mikrowellen-Bauelement.

(57) Ein Gehäuse (8) für ein Mikrowellen-Bauelement
(7) soll preiswert herzustellen und weiterzuverarbeiten sein, soll sehr hohe Frequenzen ermöglichen
und bis zu 6 elektrische Anschlüsse ermöglichen.
Das Gehäuse (8) besitzt einen Steg im Zentrum des
Gehäuses (8) zur Positionierung des Mikrowellen-
Bauelements (7) und zur Abschirmung mindestens
eines weiteren elektrischen Anschlusses (1 bzw 6)
auf einer Seite des Stegs von mindestens einem
anderen elektrischen Anschluß (3 bzw 4) auf der
anderen Seite des Stegs. Der Steg besitzt auf zwei
entgegengesetzten Seiten des Gehäuses je einen
elektrischen Anschluß (2 bzw 5). Eine Gerade kann
durch das Gehäuse (8) hindurch quer zur Längsachse des Gehäuses ihrer ganzen Länge nach im Inneren des Stegs verlaufen.

EP 0 419 709 A1

## GEHÄUSE FÜR MIKROWELLEN-BAUELEMENT

Die Erfindung betrifft ein Gehäuse für ein Mikrowellen-Bauelement und ein Leiterband (Lead-Frame) für ein solches Gehäuse.

Mikrowellen-Bauelemente, insbesondere Mikrowellen-Halbleiter-Bauelemente, sollen preiswerte Gehäuse aufweisen. Beispielsweise soll es möglich sein, Mikrowellen-Halbleiter-Bauelemente für den Frequenzbereich bis 12 GHz und auch noch oberhalb von 12 GHz in einem preiswerten Gehäuse mit bis zu 6 voneinander unabhängigen elektrischen Anschlüssen einzubringen.

Bisher werden für diesen Zweck bevorzugt Keramikgehäuse verwendet. Diese Keramikgehäuse sind jedoch in der Gestehung dieser Keramikgehäuse wie auch in der Weiterverarbeitung dieser Keramikgehäuse kostenintensiv.

Bisherige Plastikgehäuse für Mikrowellen-Bauelemente sind aufgrund geometrischer Daten im Anwendungs-Frequenzbereich nach oben limitiert. Beispielsweise ist die Verwendung eines SOT-143-Leiterbandes für ein Mikrowellen-Bauelement auf einen Anwendungsfrequenzbereich bis 8 GHz beschränkt.

Mit zunehmender Erschließung des Konsumermarktes für GaAs-Feldeffekttransistoren und GaAs-MMIC's wird der Kostenfaktor immer bedeutender. Aus diesem Grund sollen Gehäusekosten und Montagekosten weiter reduziert werden.

Mittlerweile finden Mikro-X-Plast-Gehäuse auf dem Markt Eingang. Eine dafür benötigte neue Montagelinie ist sehr kostenintensiv. Deshalb wird versucht, ein mit einer SOT-23/SOT-143-Montagelinie kompatibles SMD (Surface Mounted Device)-Gehäuse für X-Band-Anwendungen zu entwickeln, welches gleichermaßen für Single-Gate-und Dual-Gate-Feldeffekttransistoren sowie für kleine MMIC's ge eignet ist.

Der vorliegenden Erfindung liegt daher die Aufgabe zugrunde, ein Gehäuse für ein Mikrowellen-Bauelement anzugeben, das preiswert herzustellen und weiterzuverarbeiten ist, das sehr hohe Frequenzen ermöglicht und das bis zu 6 elektrische Anschlüsse ermöglicht.

Diese Aufgabe wird erfindungsgemäß durch ein Gehäuse nach dem Patentanspruch 1 gelöst.

Ausgestaltungen und Vorteile der Erfindung sind in den Unteransprüchen, der Beschreibung und der Zeichnung angegeben.

Die Erfindung ermöglicht induktionsarme elektrische Anschlüsse. Bei einem Gehäuse nach der Erfindung können lange Kontaktierdrähte zwischen dem Mikrowellen-Bauelement und den elektrischen Anschlüssen des Gehäuses vermieden werden. Bei einem Gehäuse nach der Erfindung können lange elektrische Anschlüsse des Gehäuses, insbesondere lange elektrische Anschlüsse (Leads) für die Masseanschlüsse, vermieden werden. Die Erfindung wird im folgenden anhand der Zeichnung näher erläutert.

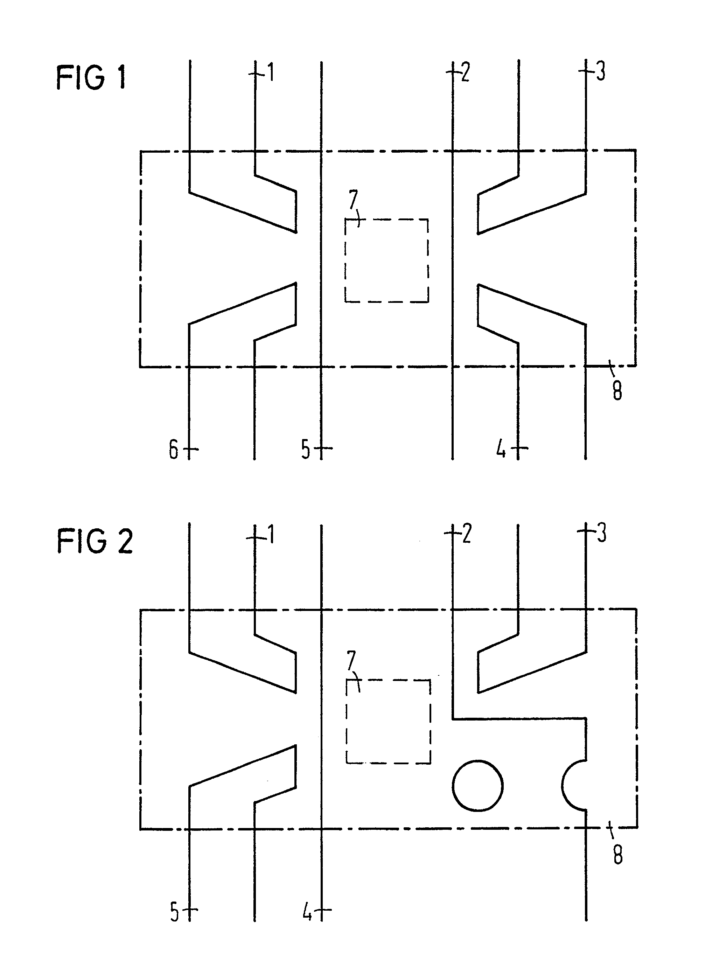

FIG 1 bis 5 zeigen verschiedene Gehäuse nach der Erfindung.

FIG 1 zeigt die Grundvariante eines Gehäuses nach der Erfindung mit bis zu 6 elektrischen Anschlüssen des Gehäuses.

Die Anschlüsse 2 und 5 stellen eine kürzestmögliche Verbindung im Zentrum des Gehäuses dar. Dieser Steg, der durch die beiden elektrischen Anschlüsse 2 und 5 gebildet wird, dient bevorzugt dem Masseanschluß. Dieser Steg dient auch der Aufnahme des Mikrowellenbauelements 7. Dieser Steg schirmt die auf einer Seite des Steges liegenden Anschlüsse 1 bzw. 6 von den auf der anderen Seite des Steges liegenden Anschlüssen 3 bzw. 4 ab. Die Anschlüsse 1, 3, 4, 6 können im Inneren des Gehäuses möglichst kapazitätsarm an das Mikrowellen-Bauelement 7 herangeführt werden, um allzu große Kontaktierdraht-Induktivitäten zwischen dem Mikrowellen-Bauelement 7 und diesen elektrischen Anschlüssen 1, 3, 4, 6 zu vermeiden. Dabei kann durch Schrägführung dieser elektrischen Anschlüsse 1, 3, 4, 6 die elektrische Verkoppelung zwischen den elektrischen Anschlüssen 1 und 6 bzw. zwischen den elektrischen Anschlüssen 3 und 4 vermindezt oder minimiert werden.

Zur Herstellung der Umhüllung 8 um die elektrischen Anschlüsse 1 bis 6 herum können alle brauchbaren Verguß-/Verspritzmassen aus Kunststoff-Material Verwendung finden.

Da die beiden elektrischen Anschlüsse 2 und 5 eine kürzestmögliche Verbindung im Zentrum des Gehäuses darstellen, kann eine Gerade durch die Gehäuseumhüllung 8 hindurch quer zur Längsachse der Umhüllung 8 ihrer ganzen Länge nach im Inneren des Stegs im Zentrum des Gehäuses verlaufen. Die beiden elektrischen Anschlüsse 2 und 5 im Zentrum des Gehäuses befinden sich auf entgegengesetzten Seiten der Gehäuseumhüllung 8 wenigstens teilweise auf gleicher Höhe der Umhüllungs-Längsseite einander wenigstens teilweise gegenüber liegend.

FIG 2 zeigt ein SOT-143-Lead Frame für eine 12 GHz-Anwendung und für GaAs-Mikrowellen-Bauelemente. Das Gehäuse gemäß FIG 2 besitzt nur 5 elektrische Anschlüsse 1 bis 5. Wie dieses Beispiel zeigt, können bei einem Gehäuse nach der Erfindung einzelne Anschlüsse entfallen. Wie dieses Beispiel nach FIG 2 weiter zeigt, können einzelne Anschlüsse intern mit dem Steg zwischen den elektrischen 2 und 4 (bei FIG 2) verbunden sein. Wie dieses Beispiel nach FIG 2 weiter zeigt, können einzelne Anschlüsse über ihre gesamte Breite hinweg mit dem Steg, der in FIG 2 aus den beiden Anschlüssen 2 und 4 gebildet ist, verbunden sein.

Ein Gehäuse nach FIG 2 ist geeignet für Single-Gate-Feldeffekttransistoren, für Dual Gate-Transistoren und für weitere Mikrowellen-Bauelemente, z. B. für MMIC's. Das Gehäuse nach FIG 2 bildet ein X-Band Mikrowellen-Plastik-Gehäuse.

Die elektrischen Anschlüsse 2 und 4 bilden in jedem Fall Masse anschlüsse (Source). Der elektrische Anschluß 3 bildet in jedem Fall beispielsweise den Drain-Anschluß. Sowohl der Anschluß 1 als auch der Anschluß 5 kann bei Verwendung des Gehäuses für einen Single-Gate-Feldeffekttransistor den Gate-Anschluß bilden.

Bei Verwendung eines Gehäuses nach FIG 2 für einen Dual Gate-Feldeffekttransistor kann der Anschluß 1 den Anschluß für Gate 1 und der Anschluß 5 den Anschluß für Gate 2 bilden. Es ist jedoch auch möglich, daß der Anschluß 1 den Anschluß für das Gate 2 und der Anschluß 5 den Anschluß für das Gate 1 bilden.

Zur Anschluß- und Lagekennung des Gehäuses können einzelne Anschlüsse in ihrer Geometrie verändert sein, beispielsweise verbreitert oder verschmälert oder verformt oder versetzt sein. Diesem Zweck der Anschluß- und Lagekennung kann auch die externe Verbindung eines Anschlusses mit dem Steg im Zentrum des Gehäuses dienen oder auch das Fehlen eines Anschlusses.

Der Steg im Zentrum des Gehäuses kann eine Unterbrechung zwischen den beiden Anschlüssen 2 und 5 in FIG 1 bzw. 2 und 4 in FIG 2 aufweisen.

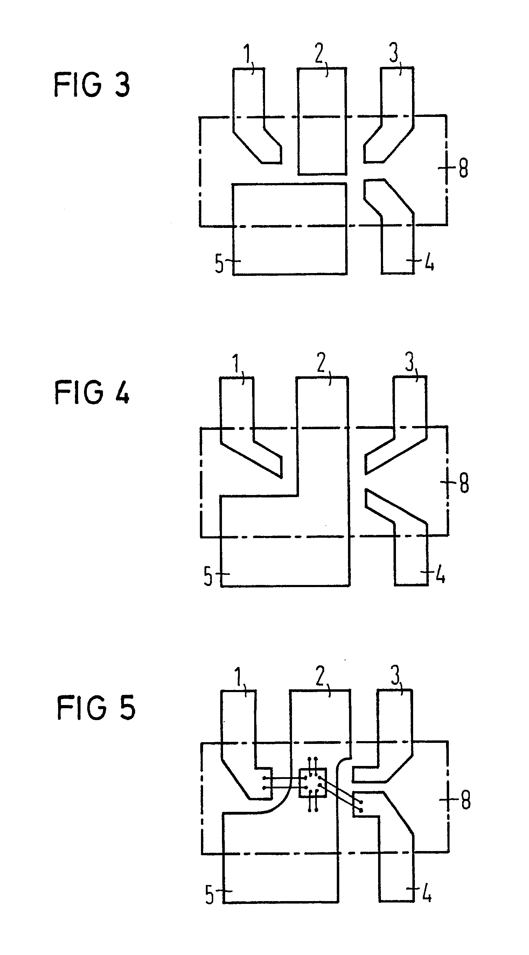

Die Verwendung des Stegs im Zentrum des Gehäuses zwischen den Anschlüssen 2 und 5 in FIG 1 bzw. zwischen den Anschlüssen 2 und 4 in FIG 2 als Masseanschluß ermöglicht eine möglichst niedrige Masseinduktivität und hervorragende Schirmungseigenschaften zur Abschirmung der Anschlüsse 1 und 6 einerseits von 3 und 4 andererseits in FIG 1 und 1 und 5 einerseits von 3 andererseits in FIG 2. Die breite Anschlußfahne 4 in FIG 2 dient neben der optischen Lagekennung einer verbesserten Wärmeableitung. Die breite Anschlußfahne 4 in FIG 2 unterstützt außerdem die automatische Sortierung.

Bei Verwendung des Gehäuses nach FIG 2 für einen Single-Gate-Feldeffekttransistor kann ein Anschluß, beispielsweise Anschluß 1 oder Anschluß 5, völlig weggelassen werden. Der Anschluß 3 ist in FIG 2 für den Drain-Anschluß reserviert.

Das Gehäuse nach FIG 2 trägt den Mikrowellen-Erfordernissen Rechnung. Das Gehäuse nach FIG 2 erfüllt die Mikrowellen-Erfordernisse mindestens ähnlich gut wie ein eigenes Mikro-X-Plastik-Gehäuse. Das Gehäuse nach FIG 2 bietet zusätzlich die Vorteile, auch für Dual Gate-Feldeffekttransistoren und kleine MMIC's geeignet zu sein. Das Gehäuse nach FIG 2 kann auf der bestehenden Montagelinie für SOT-23/SOT-143 verarbeitet werden.

Vorzugsweise befindet sich ein Massesteg mittig im Gehäuse 8.

Ein Gehäuse nach der Erfindung erfüllt Mikrowellen-Anforderungen mindestens bis 20 GHz.

Ein Gehäuse nach der Erfindung besitzt eine sehr gute Entkopplung zwischen Eingang und Ausgang. Ein Gehäuse nach der Erfindung, insbesondere nach FIG 2, besitzt eine sehr gute Entkopplung zwischen Gate 1 und Gate 2 bei Verwendung des Gehäuses für einen Dual Gate-Feldeffekttransistor.

Die Verwendung einer Umhüllung 8 aus Plastik ist preiswert und bezüglich Masseinduktivität einem Keramikgehäuse überlegen.

Bei Verwendung eines Gehäuses nach FIG 1 für einen Single-Gate-Feldeffektransistor bzw. für einen Dual Gate-Feldeffektransistor bzw. für ein MMIC-Bauelement kann auch einer der Anschlüsse, beispielsweise der Anschluß 4, als Masseanschluß verwendet werden (anstelle der Masseanschlüsse 2 und 5).

FIG 3 bis 5 zeigen weitere Ausführungsbeispiele für ein Gehäuse nach der Erfindung. Dabei bilden jeweils die Anschlüsse 2 und 5 einen Steg im Zentrum des Gehäuses. Bei FIG 3 gibt es eine Unterbrechung zwischen den Anschlüssen 2 und 5.

## Ansprüche

1. Gehäuse für ein Mikrowellen-Bauelement (7), mit einem Steg im Zentrum des Gehäuses zur Positionierung des Mikrowellen-Bauelements (7) und zur Abschirmung mindestens eines weiteren elektrischen Anschlusses auf einer Seite des Stegs von mindestens einem anderen elektrischen Anschluß auf der anderen Seite des Stegs, wobei der Steg auf zwei entgegengesetzten Seiten des Gehäuses je einen elektrischen Anschluß besitzt, und wobei eine Gerade durch das Gehäuse hindurch quer zur Längsachse des Gehäuses ihrer ganzen Länge nach im Inneren des Stegs verlaufen kann.
2. Gehäuse nach Anspruch 1,
**dadurch gekennzeichnet,** daß auf mindestens einer Seite des Stegs zwei elektrische Anschlüsse vorhanden sind, deren einander gegenüberliegende Enden zum Steg hin geführt sind zur Verminderung der elektrischen Verkoppelung zwischen diesen beiden, auf einer Seite des Stegs vorhandenen elektrischen Anschlüssen und zur Verminderung der Länge der erforderlichen Kontaktierdrähte von dem Mikrowellen-Bauelement zu dem jeweiligen elektrischen Anschlüssen.

3. Gehäuse nach Anspruch 1 oder 2,
**gekennzeichnet durch** den Steg im Zentrum des Gehäuses als Masseanschluß.

4. Gehäuse nach einem der Ansprüche 1 bis 3, **gekennzeichnet durch** eine Unterbrechung des Stegs im Zentrum des Gehäuses.

5. Gehäuse nach einem der Ansprüche 1 bis 4, **gekennzeichnet durch** zwei elektrische Anschlüsse auf jeder Seite des Stegs im Zentrum des Gehäuses.

6. Gehäuse nach einem der Ansprüche 1 bis 5, **gekennzeichnet durch** interne einstückige Verbindung mindestens eines elektrischen Anschlusses mit dem Steg im Zentrum des Gehäuses.

7. Gehäuse nach Anspruch 6, **gekennzeichnet durch** interne einstückige Verbindung mindestens eines elektrischen Anschlusses mit dem Steg im Zentrum des Gehäuses über die gesamte Breite des elektrischen Anschlusses.

8. Gehäuse nach einem der Ansprüche 1 bis 7, **gekennzeichnet durch** spezielle geometrische Formung mindestens eines elektrischen Anschlusses zur Anschluß-und/oder Lagekennung.

9. Leiterband (Lead frame) für ein Gehäuse nach einem der Ansprüche 1 bis 8.

FIG 1

FIG 2

FIG 3

FIG 4

FIG 5

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | PATENT ABSTRACTS OF JAPAN, Band 10, Nr. 289 (E-442), 2. Oktober 1986; & JP-A-61 108 157 (MATSUSHITA ELECTRIC IND. CO., LTD) 26-05-1986 * Zusammenfassung * --- | 1-3,5-7 ,9 | H 01 L 23/66 |
| Y | IDEM --- | 8 | |
| X | PATENT ABSTRACTS OF JAPAN, Band 9, Nr. 263 (E-351), 19. Oktober 1985; & JP-A-60 109 254 (HITACHI SEISAKUSHO K.K.) 14-06-1985 * Zusammenfassung * --- | 1,3,6,7 ,9 | |
| A | IDEM --- | 2 | |
| X | PATENT ABSTRACTS OF JAPAN, Band 11, Nr. 108 (E-495), 4. April 1987; & JP-A-61 255 041 (MITSUBISHI ELECTRIC CORP.) 12-11-1986 * Zusammenfassung * --- | 1-3,5-7 | |
| A | IDEM --- | 9 | RECHERCHIERTE SACHGEBIETE (Int. Cl.5) H 01 L 23/00 |
| X | PATENT ABSTRACTS OF JAPAN, Band 6, Nr. 91 (E-109), 28. Mai 1982; & JP-A-57 26 458 (HITACHI LTD) 12-02-1982 * Zusammenfassung * --- | 1-3,6,9 | |
| A | PATENT ABSTRACTS OF JAPAN, Band 7, Nr. 258 (E-211), 17. November 1983; & JP-A-58 142 576 (HITACHI SEISAKUSHO K.K.) 24-08-1983 * Zusammenfassung * --- | 1-3,6,9 | |

-/-

Der vorliegende Recherchenbericht wurde für alle Patentansprüche erstellt

| Recherchenort | Abschlußdatum der Recherche | Prüfer |
|---|---|---|
| DEN HAAG | 18-05-1990 | ZEISLER P.W. |

Europäisches Patentamt

**EUROPÄISCHER RECHERCHENBERICHT**

Nummer der Anmeldung

EP 89 11 7967

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | PATENT ABSTRACTS OF JAPAN, Band 7, Nr. 88 (E-170), 12. April 1983; & JP-A-58 15 255 (HITACHI SEISAKUSHO K.K.) 28-01-1983 * Zusammenfassung * --- | 8 | |
| A | PATENT ABSTRACTS OF JAPAN, Band 7, Nr. 45 (E-160), 23. Februar 1983; & JP-A-57 194 559 (HITACHI SEISAKUSHO K.K.) 30-11-1982 * Zusammenfassung * ----- | 8 | |

RECHERCHIERTE SACHGEBIETE (Int. Cl.5)

Der vorliegende Recherchenbericht wurde für alle Patentansprüche erstellt

| Recherchenort | Abschlußdatum der Recherche | Prüfer |
|---|---|---|
| DEN HAAG | 18-05-1990 | ZEISLER P.W. |

EPO FORM 1503 03.82 (P0403)